# EUROPÄISCHE PATENTSCHRIFT

(11) **EP 2 691 754 B1**
(45) Veröffentlichungstag und Bekanntmachung des Hinweises auf die Patenterteilung: **14.10.2020**
(21) Anmeldenummer: 12704401.4
(22) Anmeldetag: 10.02.2012
(51) Int. Cl.: G01L 19/14, G01L 13/02, G01L 9/00

(54) **DRUCKFEST GEKAPSELTER DIFFERENZDRUCKSENSOR**
PRESSURE-TIGHT ENCAPSULATED DIFFERENTIAL PRESSURE SENSOR
CAPTEUR DE PRESSION DIFFÉRENTIELLE AYANT UNE CAPSULE RÉSISTANT À LA PRESSION

(30) Priorität: 31.03.2011 DE 102011006517
(43) Veröffentlichungstag der Anmeldung: 05.02.2014
(73) Patentinhaber: Endress+Hauser SE+Co. KG, 79689 Maulburg (DE)
(72) Erfinder: THAM, Anh Tuan, 10243 Berlin (DE); PÄßLER, Frank, 12163 Berlin (DE); TEIPEN, Rafael, 10555 Berlin (DE)
(74) Vertreter: Andres, Angelika Maria
(86) Internationale Anmeldenummer: PCT/EP2012/052313
(87) Internationale Veröffentlichungsnummer: WO 2012/130512

(56) Entgegenhaltungen:
- WO-A1-2010/108949
- WO-A2-2008/089969
- DE-A1-102007 061 184
- JP-A- S 548 571
- US-A1- 2002 194 920

## Beschreibung

Die vorliegende Erfindung betrifft einen Differenzdrucksensor, insbesondere einen Differenzdrucksensor mit einem Wandlerkern, welcher ein Halbleitermaterial oder ein keramisches Material aufweist. Derartige Differenzdrucksensoren sind bekannt, wobei die Wandlerkerne insbesondere piezoresistive oder kapazitive Wandler umfassen, um eine differenzdruckabhängige Auslenkung einer Messmembran des Wandlerkerns in ein elektrisches Signal zu wandeln. Derartige Wandlerkerne werden gewöhnlich in ein Messwerk eingebaut, welches einen metallischen Werkstoff, insbesondere Stahl umfasst. Damit sind für die Aufbau- und Verbindungstechnik erhebliche Probleme vorgegeben, denn der Wärmeausdehnungskoeffizient von Silizium, einem gängigen Material für Halbleiterdruckmesswandler, beträgt ca. 3 x 10⁻⁶/K, während der Wärmeausdehnungskoeffizient für die hier relevanten VA-Stähle zwischen 10 und 16 x 10⁻⁶/K liegt. Um dem Rechnung zu tragen, wird der Wandlerkern häufig zunächst auf einem Entkopplungskörper montiert, welcher dann auf einer Oberfläche, die Stahl aufweist, beispielsweise durch Kleben oder Löten befestigt wird. Eine entsprechende Konstruktion mit einem Halbleitersockel ist beispielsweise in der deutschen Offenlegungsschrift 10 2007 053 859 A1 offenbart. Die Offenlegungsschrift DE 10 2006 057 828 A1 offenbart einen Differenzdruckmessaufnehmer, bei dem ein Wandlerkern, welcher ein piezoresistiver Siliziumchip auf einen sogenannten Messmembranträger umfasst, wobei der Messmembranträger auf der Oberfläche eines Glaskörpers befestigt ist. Die unmittelbare Befestigung eines Siliziumchips auf einem Glasträger erweist sich für Relativdrucksensoren als geeignet, ist aber für Differenzdrucksensoren insofern problematisch, als Gläser in der Regel ein geringes Kompressionsmodul als Silizium aufweisen. Dies führt zu Querempfindlichkeiten gegenüber dem statischen Druck, wie in der Offenlegungsschrift DE 10 2006 062 222 A1 beschrieben ist.

Die Offenlegungsschrift WO 2008/089969 offenbart einen MEMS Differenzdrucksensor, mit einem MEMS-Chip, der mit seiner Unterseite am Boden einer Kammer in einem Gehäuse mittels eines Klebers befestigt ist, Dass Gehäuse kann unter anderem einen keramischen Werkstoff aufweisen. Die Kammer ist mit einem Polymer, insbesondere Silikon aufgefüllt. Dies mag den MEMS-Chip vor gewissen Umwelteinflüssen schützen. Der beschriebene Differenzdrucksensor ist aber für hohe statische Drücke nicht geeignet.

Die Veröffentlichung DE 11 2004 000 818 T5 offenbart schließlich eine Drucksensorenkapsel, bei welcher ein Halbleiterabsolutdrucksensor isostatisch von einer Übertragungsflüssigkeit in einem Metallgehäuse umgeben ist, wobei der Halbleiterkörper des Drucksensors über ein sogenanntes Beanspruchungs-Isolationselement, welches einen keramischen Werkstoff aufweist, und welches im Verhältnis des Halbleiterdrucksensors eine kleine Querschnittsfläche aufweist, druckdicht an eine Durchführung in der metallischen Wand der Drucksensorenkapsel befestigt ist. Wenngleich dieser Lösungsansatz für einen Absolutdrucksensor funktionieren mag, ist er jedoch für einen Differenzdrucksensor gänzlich ungeeignet, weil ein Differenzdrucksensor grundsätzlich zwei Druckzuleitungen zu einem Wandlerkern erfordert, welche gegeneinander abgedichtet sind.

Die noch unveröffentlichte deutsche Patentanmeldung Nr. 10 2010 043043 offenbart einen Differenzmessaufnehmer, bei welchem ein Halbleiterwandlerkern in einem Gehäuse zwischen elastischen Abstützungen weich gelagert ist. Dieser Ansatz ist sicher sehr interessant, weist aber Grenzen hinsichtlich der Belastbarkeit mit statischen Drücken bzw. Differenzen zwischen statischen Drücken aus. Zudem erfordert die weiche Lagerung des Siliziumchips ein Mindestvolumen, damit sich die entkoppelnde Wirkung der elastischen Dichtungen bzw. Lager zwischen dem Siliziumchip und dem metallischen Gehäuse entfalten kann.

Die Offenlegungsschriften US 2002/194920, DE 10 2007 061 184 und DE 28 27 725 offenbaren andere Drucksensoren.

Es ist daher eine Aufgabe der vorliegenden Erfindung, einen Differenzdruckmessaufnehmer bereitzustellen, welcher die Nachteile des Stands der Technik überwindet.

Die Aufgabe wird erfindungsgemäß gelöst durch den Differenzdruckmesser gemäß dem unabhängigen Patentanspruch 1.

Der erfindungsgemäße Differenzdruckmessaufnehmer, umfasst eine Kapsel, welche einen keramischen Kapselkörper aufweist, wobei die Kapsel in ihrem Inneren eine Wandleraufnahme aufweist, wobei in der Wandleraufnahme ein Halbleiterdruckmesswandler angeordnet ist, welcher einen Messmembrankörper und mindestens einen Trägerkörper aufweist, wobei der Messmembrankörper entlang eines umlaufenden Randes druckdicht mit dem mindestens einen Trägerkörper verbunden ist, wobei der Trägerkörper mindestens eine Druckeinlassöffnung aufweist, wobei sich ein erster Kanal und ein zweiter Kanal jeweils von einer äußeren Oberfläche der Kapsel in die Wandleraufnahme erstrecken; wobei die Druckeinlassöffnung mit dem ersten Kanal kommuniziert, wobei eine erste Seite der Messmembran, welche dem mindestens einen Trägerkörper zugewandt ist, durch die mindestens eine Druckeinlassöffnung mit einem durch den ersten Kanal eingeleiteten Druck beaufschlagbar ist, wobei der mindestens eine Trägerkörper mit einer drucktragenden Fügestelle, welche die erste Druckeinlassöffnung druckdicht umgibt, und welche die Mündung des ersten Kanals in die Wandleraufnahme umgibt, mit einer Wand der Wandleraufnahme druckdicht verbunden ist, und wobei eine zweite Seite der Messmembran, welche der ersten Seite der Messmembran abgewandt ist, von der ersten Seite der Messmembran hydraulisch isoliert ist und mit dem zweiten Kanal kommuniziert, wobei der Kapselkörper einen ersten Teilkörper und einen zweiten Teilkörper auf, wobei der erste Teilkörper und der zweite Teilkörper miteinander entlang einer zweiten Fügestelle druckdicht gefügt sind, wobei der erste Teilkörper und der zweite Teilkörper im Wesentlichen zueinander symmetrisch sind, wobei der Wandlerkern einen zweiten Trägerkörper auf, wobei der Messmembrankörper zwischen dem ersten und dem zweiten Trägerkörper angeordnet und mit beiden Trägerkörpern druckdicht verbunden ist, wobei der zweite Trägerkörper mit einer dritten Fügestelle mit einer Wand der Wandleraufnahme druckdicht verbunden ist, wobei der Wandlerkern im Wesentlichen symmetrisch aufgebaut und symmetrisch in der Wandlerkammer angeordnet ist.

Gemäß einer Weiterbildung der Erfindung weist der Trägerkörper des Halbleiterdruckmesswandlers einen ersten effektiven Wärmeausdehnungskoeffizienten α₁ auf, wobei der keramische Werkstoff des Kapselkörpers einen zweiten Wärmeausdehnungskoeffizienten α₂ aufweist, wobei gilt... |(α₁- α₂)/(α₁ + α₂)| < 0,25 insbesondere < 0,2, vorzugsweise <0,15.

Gemäß einer Weiterbildung der Erfindung weist die mindestens eine erste Fügestelle zwischen dem Wandlerkern und einer Wand der Wandleraufnahme Glas auf.

Gemäß einer Weiterbildung der Erfindung weist die Fügestelle eine Stärke von nicht mehr als 100 µm, insbesondere nicht mehr als 75 µm und bevorzugt nicht mehr als 50 µm auf.

In einer Weiterbildung der Erfindung weist die dritte Fügestelle eine Öffnung auf, welche mit dem zweiten Kanal fluchtet, wobei der zweite Trägerkörper eine

Druckeinlassöffnung aufweist, welche mit einer zweiten Seite der Messmembran kommuniziert, wobei die Druckeinlassöffnung mit dem zweiten Kanal fluchtend angeordnet ist, um die zweite Seite der Messmembran mit einem durch den zweiten Kanal eingeleiteten Druck zu beaufschlagen.

In einer Weiterbildung der Erfindung weist die Wandleraufnahme elektrische Kontaktpunkte auf, über welche der Wandlerkern in der Flip-Chip-Technologie kontaktiert ist, wobei die Kontaktpunkte über elektrische Durchführungen zu elektrischen Anschlüssen an einer äußeren Oberfläche der Druckkapsel geführt sind.

In einer Weiterbildung der Erfindung weisen der erste Teilkörper und der zweite Teilkörper im Bereich der ersten bzw. dritten Fügestelle einen ersten keramischen Werkstoff, auf dessen Wärmeausdehnungskoeffizient dem effektiven Wärmeausdehnungskoeffizienten des Wandlerkerns angepasst ist, und wobei der erste und der zweite Teilkörper in einem von der ersten bzw. dritten Fügestelle abgewandten Bereich jeweils einen zweiten keramischen Werkstoff aufweisen, dessen Wärmeausdehnungskoeffizient dem Wärmeausdehnungskoeffizienten eines metallischen Werkstoffs angepasst sind, wobei der erste Kanal und der zweite Kanal jeweils in einem Bereich einer äußeren Oberfläche des ersten bzw. zweiten Teilkörpers münden, welcher den zweiten keramischen Werkstoff aufweist, wobei der erste und der zweite Kanal jeweils mit einer ersten bzw. zweiten Kapillarleitung kommunizieren, welche den metallischen Werkstoff aufweisen, und welche druckdicht mit der Kapsel verbunden sind, um einen ersten bzw. zweiten Druck in die Wandleraufnahme einzuleiten.

In einer Weiterbildung der Erfindung bildet die Wandleraufnahme eine druckdichte Wandlerkammer, in welcher der Wandler angeordnet ist.

In einer Weiterbildung der Erfindung kommuniziert der zweite Kanal mit dem Volumen in der Wandlerkammer außerhalb des Wandlers, um den Wandler auf seinen äußeren Oberflächen mit dem über den zweiten Kanal eingeleiteten Druck isostatisch zu beaufschlagen.

Die Erfindung wird nun anhand der in den Zeichnungen dargestellten Ausführungsbeispiele erläutert. Es zeigt:
- Fig.1:: einen Längsschnitt durch ein erstes Ausführungsbeispiel eines erfindungsgemäßen Differenzdruckmessaufnehmers; und
- Fig. 2:: einen Längsschnitt durch ein Beispiel eines nicht erfindungsgemäßen Differenzdruckmessaufnehmers.

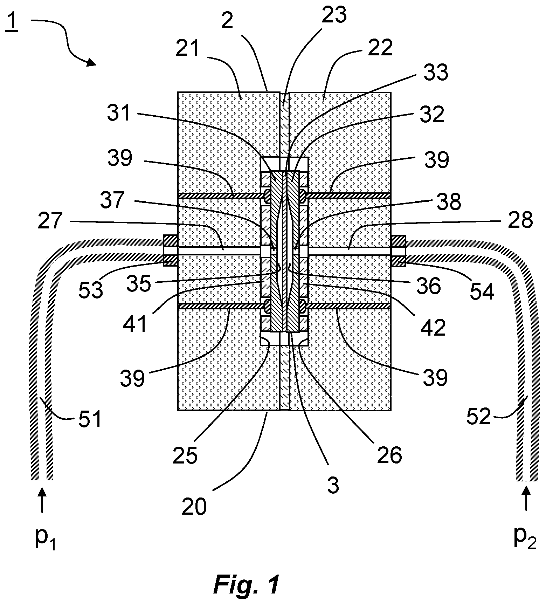

Der in Fig. 1 dargestellte Differenzdruckmessaufnehmer 1 umfasst eine Kapsel 2, in welcher ein Halbleiterdruckmesswandler 3 angeordnet ist. Die Kapsel 2 umfasst einen keramischen Kapselkörper 20, welcher aus zwei keramischen Teilkörpern 21', 22 gebildet ist, die entlang einer Fügestelle 23, welche insbesondere ein Glaslot aufweist, miteinander verbunden sind. Der Halbleiterdruckmesswandler 3 umfasst einen ersten Trägerkörper 31, einen zweiten Trägerkörper 32 und einen Messmembrankörper 33, welcher an beiden Trägerkörpern druckdicht befestigt ist. Die Trägerkörper 31, 32 weisen jeweils in ihrer der Messmembran zugewandten Stirnfläche eine Aussparung 35, 36 auf, wobei die Oberflächen der Trägerkörper 31 und 32, welche die Aussparungen 35 und 36 begrenzen, insbesondere als Membranbett dienen können, an welchem sich die Messmembran 33 im Falle einer Überlast anlegen kann. Der erste und zweite Trägerkörper 31, 32 weisen jeweils eine Bohrung 37, 38 auf, durch welche die Messmembran 33 jeweils mit einem Druck p₁, p₂ beaufschlagbar ist, wobei die Messmembran 33 eine Auslenkung erfährt, die von der Druckdifferenz p₁ - p₂ abhängt. Im vorliegenden Ausführungsbeispiel ist der Halbleiterdruckmesswandler ein kapazitiver Druckmesswandler, wobei der erste Trägerkörper und der zweite Trägerkörper jeweils mindestens eine Gegenelektrode aufweisen, und wobei jeweils die Kapazität zwischen der Gegenelektrode und der Messmembran in die Bestimmung der Druckdifferenz p₁ - p₂ eingeht.

Die Trägerkörper 31, 32 und die Messmembran 33 weisen insbesondere Silizium auf, wobei die Messmembran vorzugsweise hoch dotiertes Silizium aufweist, und wobei die Gegenelektroden ebenfalls durch Dotieren oder über metallische Beschichtungen präpariert sind. Zum Ableiten der elektrischen Signale des Halbleiterdruckmesswandlers 3 sind elektrische Durchführungen 39 durch den Kapselkörper 2 vorgesehen, wobei die elektrischen Durchführungen 39 den Halbleiterdruckmesswandler an Grundflächen der Trägerkörper 31, 32, insbesondere mittels der Flip-Chip-Technologie, kontaktieren. Der Halbleiterdruckmesswandler 3 ist in der durch die Aussparungen 25, 26 gebildeten Wandlerkammer im Inneren des Kapselkörpers 2 zu beiden Teilkörpern des Kapselkörpers hin mit einer drucktragenden Fügestelle 41, 42 abgestützt, wobei die Fügestelle insbesondere Glas aufweist. Durch den ersten und zweiten Teilkörper und durch die Fügestellen zwischen dem Halbleiterdruckmesswandler 3 und den Teilkörpern 21, 22 erstreckt sich jeweils ein Kanal 27, 28, welcher mit der jeweiligen Druckeinlassöffnung 37, 38 im Membranträgerkörper fluchtet, so dass der Halbleiterdruckmesswandler 3 durch die Kanäle 27, 28 mit dem ersten und zweiten Druck beaufschlagbar ist, um deren Differenz zu bestimmen. Die Materialien der Teilkörper, der Fügestelle zwischen den Teilkörpern und der Fügestellen zwischen den Halbleitern und dem Halbleiterdruckmesswandler sowie die Stärke der Fügestellen, und die Tiefe der Aussparungen 25, 26 in den Stirnflächen der Teilkörper 21, 22 sind solchermaßen auf die Abmessungen des Halbleiterdruckmesswandlers 3 abgestimmt, dass mechanische Spannungen aufgrund von Temperaturschwankungen trotz der unterschiedlichen Wärmeausdehnungskoeffizienten der beteiligten Materialien nicht zu einer permanenten Schädigung des Halbleiterdruckmesswandlers oder zu einer Verfälschung des Messwerts führen. Als Material für den Kapselkörper sind insbesondere Cordierit, Mulit, Siliziumkarbid, Siliziumnitrid und Aluminiumnitrid geeignet. Für die Fügestellen kommt insbesondere ein Glaslot in Betracht. Die Aussparungen im Halbleiterdruckmesswandler 35, 36 können mit den üblichen Halbleiterprozessierungsverfahren, insbesondere anisotropen Ätzen, mit fotolithographischen Verfahren oder mittels Laserablation präpariert werden. Um den Halbleiterdruckmessaufnehmer 1 mit dem ersten Druck p₁ und dem zweiten Druck p₂ zu beaufschlagen, können beispielsweise metallische Kapillarleitungen 51, 52 mittels einer Hartlotfügung 53, 54 an die Kanäle 27, 28 anschließend am Kapselkörper 2 befestigt werden.

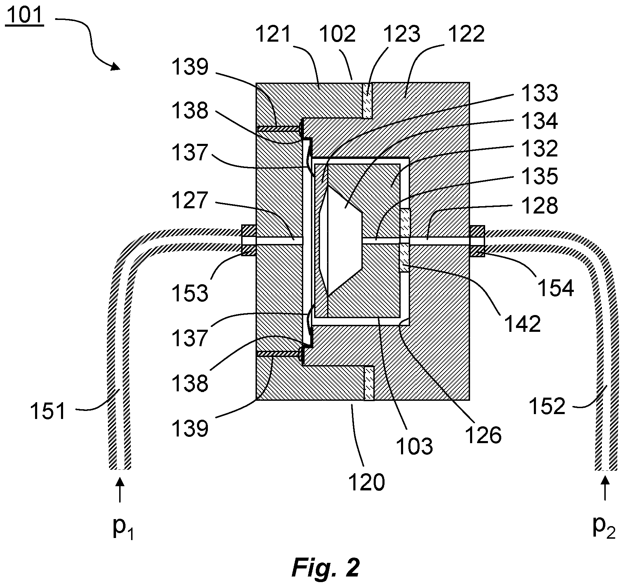

Der in Fig. 2 dargestellte Differenzdruckmessaufnehmer 101 umfasst eine Kapsel 102, in welcher ein Halbleiterdruckmesswandler 103 angeordnet ist. Die Kapsel 102 umfasst einen keramischen Kapselkörper 120, welcher aus zwei keramischen Teilkörpern 121, 122 gebildet ist, die entlang einer Fügestelle 123, welche insbesondere ein Glaslot aufweist, miteinander druckdicht verbunden sind.

Der Halbleiterdruckmesswandler 103 ist in einer durch eine Aussparung 126 in dem zweiten Teilkörper 122 gebildeten Wandlerkammer im Inneren des Kapselkörpers 120 angeordnet und an dem zweiten Teilkörper 122 des Kapselkörpers mit einer drucktragenden Fügestelle 142 befestigt, wobei die Fügestelle insbesondere ein Glaslot aufweist. Durch den ersten und zweiten Teilkörper 121, 122 erstreckt sich jeweils ein Kanal 127, 128 um die beiden Drücke, deren Differenz zu ermitteln ist, in die Wandlerkammer einzuleiten. Die Fügestelle 142 zwischen dem Halbleiterdruckmesswandler 103 und dem zweiten Teilkörper 122 umschließt einen Durchgang zum Halbleiterdruckmesswandler, wobei der Durchgang mit dem Kanal 128 durch den zweiten Teilkörper 122 fluchtet.

Der Halbleiterdruckmesswandler 103 umfasst einen Trägerkörper 132 und einen Messmembrankörper 133, welcher an dem Trägerkörper druckdicht befestigt ist, wobei die Fügestelle 142 zwischen dem Halbleiterdruckmesswandler und dem zweiten Teilkörper 122, zwischen dem Trägerkörper 132 und dem zweiten Teilkörper ausgebildet ist. Der Trägerkörper 132 weist optional in seiner der Messmembran zugewandten Stirnfläche eine Aussparung 134 auf, welches zur Symmetrisierung der Volumina in der Kapsel auf beiden Seiten der Messmembran 133 beiträgt. Der Trägerkörper 132 weist eine Bohrung 135 auf, durch welche die Messmembran 133 mit einem Druck p₂ beaufschlagbar ist. Die Bohrung 135 fluchtet mit dem Durchgang durch die Fügestelle 142 und mit dem Kanal 128 durch den zweiten Teilkörper.

Auf ihrer dem Trägerkörper 132 abgewandten Außenseite ist die Messmembran 133 mit einem Druck p₁ beaufschlagbar, welcher durch den Kanal 127, der durch den ersten Teilkörper 121 verläuft, in die Messzelle einleitbar ist, wobei dieser Druck p₁ nicht nur auf die Außenseite der Messmembran 133, sondern auch auf die Außenflächen des Trägerkörpers 132 außerhalb der Fügestelle 142 wirkt, so dass der Halbleiterdruckmesswandler 103 weitgehend isostatisch gelagert ist. Die mechanische Belastung des Halbleiterdruckmesswandlers ist dann, abgesehen von der Kompression der Werkstoffe aufgrund des statischen Drucks, gegeben durch die Differenz der beiden Drücke p₁ -p₂. Sofern absehbar ist, welcher der betrachteten Drücke größer sein wird, ist es derzeit bevorzugt, wenn der größere Druck als p₁ auf die Außenseite des Halbleiterdruckmesswandlers 103 geleitet wird.

Im vorliegenden Ausführungsbeispiel ist der Halbleiterdruckmesswandler 103 als piezoresistiver Druckmesswandler ausgestaltet, wobei die Messmembran 133 eindotierte Messwiderstände insbesondere in Form einer Vollbrückenschaltung aufweist. Sowohl die Messmembran 133 als auch der Trägerkörper 132 weisen in einer derzeit bevorzugten Ausgestaltung der Erfindung Silizium auf.

Zum Ableiten der elektrischen Signale der Halbleiterdruckmesswandlers 103 sind elektrische Durchführungen 139 durch den Kapselkörper 102 vorgesehen, wobei die elektrischen Durchführungen 139 den Halbleiterdruckmesswandler 103 in dieser Ausgestaltung nicht direkt kontaktieren. Stattdessen führen Bond-Drähte 137 von Kontaktflächen am Rand der Messmembran 133 zu metallischen Leiterbahnen 138, die auf einer Stirnfläche des zweiten Teilkörpers 122 präpariert sind. Diese Leiterbahnen werden von den elektrischen Durchführungen 139 kontaktiert, die sich durch den ersten Teilkörper 121 erstrecken.
Als Material für die Teilkörper 121, 122 des Kapselkörpers 102 sind insbesondere Cordierit, Mulit, Siliziumkarbid, Siliziumnitrid und Aluminiumnitrid geeignet. Für die Fügestellen kommt insbesondere ein Glaslot in Betracht.

Um den Halbleiterdruckmessaufnehmer 101 mit dem ersten Druck p₁ und dem zweiten Druck p₂ zu beaufschlagen, können beispielsweise metallische Kapillarleitungen 151, 152 mittels einer Hartlotfügung 153, 154 an die Kanäle 127, 128 anschließend am Kapselkörper 102 befestigt werden.

## Patentansprüche

1. Differenzdruckmessaufnehmer (1), umfassend:
eine Kapsel (2), welche einen keramischen Kapselkörper (20) aufweist, wobei die Kapsel (2) in ihrem Inneren eine Wandleraufnahme aufweist,
wobei in der Wandleraufnahme ein Halbleiterdruckmesswandler (3) angeordnet ist, welcher einen Messmembrankörper (33) und einen ersten Trägerkörper (31) aufweist, wobei der Messmembrankörper (33) entlang eines umlaufenden Randes druckdicht mit dem ersten Trägerkörper (31) verbunden ist, wobei der erste Trägerkörper eine erste Druckeinlassöffnung (37) aufweist,
wobei sich ein erster Kanal und ein zweiter Kanal (27, 28) jeweils von einer äußeren Oberfläche der Kapsel (2) in die Wandleraufnahme erstrecken;
wobei die erste Druckeinlassöffnung (37) mit dem ersten Kanal (27) kommuniziert,
wobei eine erste Seite der Messmembran (33), welche dem ersten Trägerkörper (31) zugewandt ist, durch die erste Druckeinlassöffnung (37) mit einem durch den ersten Kanal (27) eingeleiteten Druck beaufschlagbar ist,
wobei der erste Trägerkörper (31) mit einer drucktragenden ersten Fügestelle (41), welche die erste Druckeinlassöffnung (37) druckdicht umgibt, und welche die Mündung des ersten Kanals (27) in die Wandleraufnahme umgibt,
mit einer Wand der Wandleraufnahme druckdicht verbunden ist, und
wobei eine zweite Seite der Messmembran, welche der ersten Seite der Messmembran abgewandt ist, von der ersten Seite der Messmembran hydraulisch isoliert ist und mit dem zweiten Kanal (28) kommuniziert,
**dadurch gekennzeichnet, dass**
der Kapselkörper (20) einen ersten Teilkörper (21) und einen zweiten Teilkörper (32) aufweist,
wobei der erste Teilkörper und der zweite Teilkörper miteinander entlang einer zweiten Fügestelle (23) druckdicht gefügt sind, wobei die zweite Fügestelle (23) ein Glas umfasst,
wobei der erste Teilkörper (21) und der zweite Teilkörper (22) zueinander symmetrisch sind,
der Halbleiterdruckmesswandler (3) einen zweiten Trägerkörper (32) aufweist, wobei der Messmembrankörper zwischen dem ersten und dem zweiten Trägerkörper angeordnet und mit beiden Trägerkörpern druckdicht verbunden ist,
der zweite Trägerkörper (32) mit einer dritten Fügestelle (42) mit einer Wand der
Wandleraufnahme druckdicht verbunden ist, und
der Halbleiterdruckmesswandler (3) symmetrisch aufgebaut und symmetrisch in der Wandlerkammer angeordnet ist.

2. Differenzdruckmesser nach Anspruch 1, wobei der Trägerkörper des Halbleiterdruckmesswandlers einen ersten effektiven Wärmeausdehnungskoeffizienten α₁ aufweist, und wobei der keramische Werkstoff des Kapselkörpers einen zweiten Wärmeausdehnungskoeffizienten α₂ aufweist, wobei gilt... |(α₁ - α₂)/(α₁ + α₂)| < 0,25 insbesondere < 0,2, vorzugsweise <0,15.

3. Differenzdruckmessaufnehmer nach Anspruch 1 oder 2, wobei die erste Fügestelle zwischen dem Halbleiterdruckmesswandler (3) und einer Wand der Wandleraufnahme Glas aufweist.

4. Differenzdruckmessaufnehmer nach Anspruch 3, wobei die erste Fügestelle eine Stärke von nicht mehr als 100 µm, insbesondere nicht mehr als 75 µm und bevorzugt nicht mehr als 50 µm aufweist.

5. Differenzdruckmessaufnehmer nach Anspruch 1, wobei die dritte Fügestelle eine Öffnung aufweist, welche mit dem zweiten Kanal fluchtet, wobei der zweite Trägerkörper eine Druckeinlassöffnung aufweist, welche mit einer zweiten Seite der Messmembran kommuniziert, wobei die Druckeinlassöffnung mit dem zweiten Kanal fluchtend angeordnet ist, um die zweite Seite der Messmembran mit einem durch den zweiten Kanal eingeleiteten Druck zu beaufschlagen.

6. Differenzdruckmessaufnehmer nach einem der vorhergehenden Ansprüche, wobei die Wandleraufnahme elektrische Kontaktpunkte aufweist, über welche der Wandlerkern in der Flip-Chip-Technologie kontaktiert ist, wobei die Kontaktpunkte über elektrische Durchführungen zu elektrischen Anschlüssen an einer äußeren Oberfläche der Druckkapsel geführt sind.

7. Differenzdruckmessaufnehmer nach Anspruch 1, wobei der erste Teilkörper und der zweite Teilkörper im Bereich der ersten bzw. dritten Fügestelle einen ersten keramischen Werkstoff aufweisen, dessen Wärmeausdehnungskoeffizient dem effektiven Wärmeausdehnungskoeffizienten des Wandlerkerns angepasst ist, und wobei der erste und der zweite Teilkörper in einem von der ersten bzw. dritten Fügestelle abgewandten Bereich jeweils einen zweiten keramischen Werkstoff aufweisen, dessen Wärmeausdehnungskoeffizient dem Wärmeausdehnungskoeffizienten eines metallischen Werkstoffs angepasst sind, wobei der erste Kanal und der zweite Kanal jeweils in einem Bereich einer äußeren Oberfläche des ersten bzw. zweiten Teilkörpers münden, welcher den zweiten keramischen Werkstoff aufweist, wobei der erste und der zweite Kanal jeweils mit einer ersten bzw. zweiten Kapillarleitung kommunizieren, welche den metallischen Werkstoff aufweisen, und welche druckdicht mit der Kapsel verbunden sind, um einen ersten bzw. zweiten Druck in die Wandleraufnahme einzuleiten.

8. Differenzdruckmessaufnehmer nach einem der vorhergehenden Ansprüche, wobei die Wandleraufnahme eine druckdichte Wandlerkammer bildet, in welcher der Halbleiterdruckmesswandler angeordnet ist.

9. Differenzdruckmessaufnehmer nach Anspruch 7, wobei der zweite Kanal mit dem Volumen in der Wandlerkammer außerhalb des Halbleiterdruckmesswandlers kommuniziert, um den Halbleiterdruckmesswandler auf seinen äußeren Oberflächen mit dem über den zweiten Kanal eingeleiteten Druck isostatisch zu beaufschlagen.

## Claims

1. Differential pressure sensor (1), comprising:
a capsule (2) which has a ceramic capsule body (20), wherein the capsule (2) has a transducer support in the capsule interior,
wherein a semi-conductor pressure transducer (3) is arranged in the transducer support, said transducer having a measuring membrane body (33) and a first carrier body, wherein the measuring membrane body (33) is connected to the first carrier body (31) in a pressure-tight manner along a circumferential edge, wherein the first carrier body has a first pressure entry opening (37),
wherein a first channel and a second channel (27, 28) each extend from an exterior surface of the capsule (2) into the transducer support;
wherein the first pressure entry opening communicates with the first channel,
wherein a first side of the measuring membrane (22) facing towards the first carrier body (31) can be subject to a pressure introduced through the first channel (27) by means of the first pressure entry opening (37),
wherein the first carrier body (31) is connected to a wall of the transducer support in a pressure-tight manner with a pressure-bearing first joint (41) that surrounds the first pressure entry opening (37) in a pressure-tight manner,
and wherein a second side of the measuring membrane facing away from the first side of the measuring membrane is hydraulically isolated from the first side of the measuring membrane and communicates with the second channel (28),
**characterized in that**
the capsule body (20) has a first subcomponent (21) and a second subcomponent (32),
wherein the first subcomponent and the second subcomponent are joined together in a pressure-tight manner along a second joint (23), wherein the second joint (23) comprises a glass,
wherein the first subcomponent (21) and the second subcomponent (22) are symmetrical in relation to one another,
wherein the semi-conductor pressure transducer (3) has a second carrier body (32), wherein the measuring membrane body is arranged between the first and the second carrier body and is connected to both carrier bodies in a pressure-tight manner,
wherein the second carrier body (32) is connected in a pressure-tight manner to a wall of the transducer support via a third joint (42), and
wherein the semi-conductor pressure transducer (3) is symmetrically designed and is arranged symmetrically in the transducer chamber.

2. Differential pressure sensor as claimed in Claim 1, wherein the carrier body of the semi-conductor pressure transducer has a first effective thermal expansion coefficient σ₁, and wherein the ceramic material of the capsule body has a second thermal expansion coefficient σ₂, wherein the following rule applies : |(σ₁ - σ₂) / ( σ₁ + σ₂)| < 0.25, particularly < 0.2, preferably < 0.15.

3. Differential pressure sensor as claimed in Claim 1 or 2, wherein the first joint between the semi-conductor pressure transducer (3) and a wall of the transducer support features glass.

4. Differential pressure sensor as claimed in Claim 3, wherein the first joint has a thickness less than 100 µm, particularly less than 75 µm and preferably less than 50 µm.

5. Differential pressure sensor as claimed in Claim 1, wherein the third joint has an opening, said opening being aligned with the second channel, wherein the second carrier body has a pressure entry opening that communicates with a second side of the measuring membrane, wherein the pressure entry opening is arranged such that it is aligned with the second channel in order to apply a pressure, introduced through the second channel, on the second side of the measuring membrane.

6. Differential pressure sensor as claimed in one of the previous claims, wherein the transducer support features electrical contact points via which the transducer core is contacted via flip chip technology, wherein the contact points are routed via electrical feedthroughs to electrical connections on an exterior surface of the pressure capsule.

7. Differential pressure sensor as claimed in Claim 1, wherein the first subcomponent and the second subcomponent feature a first ceramic material in the area of the first or third joint, wherein the thermal expansion coefficient of said material is adapted to the effective thermal expansion coefficient of the transducer core, and wherein, in an area facing away from the first or the third joint, the first and the second subcomponent each feature a second ceramic material whose thermal expansion is adapted to the thermal expansion coefficient of a metal material, wherein the first channel and the second channel each enter into an area of an outer surface of the first and the second subcomponent that features the second ceramic material, wherein the first and the second channel each communicate with a first and a second capillary line, wherein said lines feature the metal material and are connected to the capsule in a pressure-tight manner, in order to introduce a first and a second pressure into the transducer support.

8. Differential pressure sensor as claimed in one of the previous claims, wherein the transducer support forms a pressure-tight transducer chamber in which the semi-conductor pressure transducer is arranged.

9. Differential pressure sensor as claimed in Claim 7, wherein the second channel communicates with the volume in the transducer chamber outside the semi-conductor pressure transducer in order to isostatically apply the pressure, which is introduced via the second channel, on the semi-conductor pressure transducer on the transducer's outer surfaces.

## Revendications

1. Capteur de pression différentielle (1), comprenant :
une capsule (2), laquelle capsule comporte un corps de capsule (20) en céramique, la capsule (2) comportant dans son intérieur un logement de transducteur,
un transducteur de pression à semi-conducteurs (3) étant disposé dans le logement de transducteur, lequel transducteur comporte un corps de membrane de mesure (33) et un premier corps support, le corps de membrane de mesure (33) étant relié de façon étanche à la pression, le long d'un bord périphérique, avec le premier corps support (31), le corps support comportant une ouverture d'entrée de pression (37),
un premier canal et un deuxième canal (27, 28) s'étendant respectivement depuis une surface extérieure de la capsule (2) dans le logement de transducteur ;
la première ouverture d'entrée de pression communiquant avec le premier canal, un premier côté de la membrane de mesure (22), lequel côté est tourné vers le premier corps support (31), pouvant être alimenté, à travers la première ouverture d'entrée de pression (37), avec une pression initiée par le premier canal (27),
le premier corps support (31) étant relié - de façon étanche à la pression via une première zone de jointure (41), laquelle entoure de façon étanche à la pression la première ouverture d'entrée de pression (37), et laquelle entoure l'embouchure du premier canal (27) dans le logement de transducteur - avec une paroi du logement de transducteur, et
un deuxième côté de la membrane de mesure, lequel est détourné du premier côté de la membrane de mesure, étant isolé hydrauliquement du premier côté de la membrane de mesure et communiquant avec le deuxième canal (28),
**caractérisé**
**en ce que** le corps de capsule (20) comporte un premier corps partiel (21) et un deuxième corps partiel (32),
le premier corps partiel et le deuxième corps partiel étant assemblés entre eux de façon étanche à la pression le long d'une deuxième zone de jointure (23), la deuxième zone de jointure (23) comprenant un verre,
le premier corps partiel (21) et le deuxième corps partiel (22) étant symétriques l'un par rapport à l'autre,
le transducteur de pression à semi-conducteurs (3) comportant un deuxième corps support (32), le corps de membrane de mesure étant disposé entre le premier et le deuxième corps support et relié de façon étanche à la pression avec les deux corps supports,
le deuxième corps support (32) étant relié via une troisième zone de jointure (42) de façon étanche à la pression avec une paroi du support de transducteur, et
le transducteur de pression à semi-conducteurs (3) étant conçu de façon symétrique et disposé de façon symétrique dans la chambre de transducteur.

2. Capteur de pression différentielle selon la revendication 1, pour lequel le corps support du transducteur de pression à semi-conducteurs présente un premier coefficient effectif de dilatation thermique σ₁, et le matériau céramique du corps de capsule présentant un deuxième coefficient de dilatation thermique σ₂, la règle suivante étant applicable : |(σ₁ - σ₂) / (σ₁ + σ₂)|< 0,25, notamment < 0,2, de préférence < 0,15.

3. Capteur de pression différentielle selon la revendication 1 ou 2, pour lequel la première zone de jointure comprend du verre entre le transducteur de pression à semi-conducteurs (3) et une paroi du support de transducteur.

4. Capteur de pression différentielle selon la revendication 3, pour lequel la première zone de jointure présente une épaisseur inférieure à 100 µm, notamment inférieure à 75 µm et de préférence inférieure à 50 µm.

5. Capteur de pression différentielle selon la revendication 1, pour lequel la troisième zone de jointure présente une ouverture, laquelle ouverture est alignée avec le deuxième canal, le deuxième corps support présentant une ouverture d'entrée de pression, laquelle ouverture communique avec un deuxième côté de la membrane de mesure, l'ouverture d'entrée de pression étant disposée de façon alignée avec le deuxième canal, et le deuxième côté de la membrane de mesure pouvant être alimenté avec la pression initiée par le deuxième canal.

6. Capteur de pression différentielle selon l'une des revendications précédentes, pour lequel le support de transducteur comporte des points de contact électriques, par l'intermédiaire desquels le noyau du transducteur est mis en contact avec la technologie Flip Chip, les points de contact étant acheminés via des passages électriques aux connexions électriques sur une surface extérieure de la capsule de pression.

7. Capteur de pression différentielle selon la revendication 1, pour lequel le premier corps support et le deuxième corps support présentent, dans la zone de la première ou de la troisième zone de jointure, un premier matériau céramique, dont le coefficient de dilatation thermique est adapté au coefficient de dilatation thermique effectif du noyau de transducteur, et le premier et le deuxième corps partiel présentant chacun, dans une zone détournée de la première ou de la troisième zone de jointure, un deuxième matériau céramique, dont le coefficient de dilatation thermique est adapté au coefficient de dilatation thermique d'un matériau métallique, le premier canal et le deuxième canal débouchant dans une zone d'une surface extérieure du premier et du deuxième corps partiel, laquelle zone présente le deuxième matériau céramique, le premier et le deuxième canal communiquant respectivement avec un premier et un deuxième tube capillaire, lesquels tubes présentent le matériau métallique, et lesquels tubes sont reliés de façon étanche à la pression avec la capsule, afin d'initier une première et une deuxième pression dans le support de transducteur.

8. Capteur de pression différentielle selon l'une des revendications précédentes, pour lequel le support de transducteur forme une chambre de transducteur étanche à la pression, dans laquelle le transducteur de pression à semi-conducteurs est disposé.

9. Capteur de pression différentielle selon la revendication 7, pour lequel le deuxième canal communique avec le volume de la chambre de transducteur, à l'extérieur du transducteur de pression à semi-conducteurs, afin d'alimenter de manière isostatique le transducteur de pression à semi-conducteurs, sur ses surfaces extérieures, avec la pression appliquée par l'intermédiaire du deuxième canal.
